# EUROPÄISCHE PATENTANMELDUNG

(11) **EP 1 250 037 A2**
(43) Veröffentlichungstag der Anmeldung: **16.10.2002**
(21) Anmeldenummer: 02100229.0
(22) Anmeldetag: 08.03.2002
(51) Int. Cl.: H05K 13/00

(54) **Verfahren zum Bestücken und Schutzeinrichtung für Bestückeinrichtungen**

(30) Priorität: 27.03.2001 DE 10114954
(71) Anmelder: SIEMENS AKTIENGESELLSCHAFT, 80333 München (DE)
(72) Erfinder: Raabe, Martin, 76646, Bruchsal (DE); Zoller, Marc, 76199, Karlsruhe (DE)

(57) **Zusammenfassung**

Verfahren zum Bestücken und Schutzeinrichtung für Bestückeinrichtungen, mittels welcher das Freigeben des Transports von zu bestückenden Substraten (100) nach dem Bestücken in einer Bestückposition schneller erfolgen kann. Hierzu wird von einem Wegaufnehmer (320, 340) die Position eines Trägers (200), mittels welchem die Substrate (100) während des Bestückens abgestützt werden, relativ zu der Oberfläche der Substrate (100) erfasst. Von einer Steuervorrichtung wird der erfasste Abstand des Trägers (200) von dem Substrat (100) mit einer vorgebbaren Sicherheitsposition (S) verglichen, welche mindestens um die Höhe (h) des größten bestückten Bestückelements (150) von dem Substrat (100) beabstandet ist. Erfindungsgemäß wird erreicht, dass sowohl ein sicheres Transportieren des bestückten Substrats (100) aus der Bestückposition möglich ist, als auch ein schneller Weitertransport des Substrats (100), ohne das vollständige Entfernen des Trägers (200) von dem Substrat (100) abwarten zu müssen.

## Beschreibung

Die Erfindung betrifft ein Verfahren zum Bestücken sowie eine Schutzeinrichtung für Bestückeinrichtungen, in welchen Substrate an ihren Oberflächen mit Bestückelementen versehen werden.

Beim Bestücken von Substraten mit Bestückelementen werden Transportvorrichtungen verwendet, welche die Substrate lediglich an ihren Randbereichen unterstützen. Die derart unterstützten Substrate werden mittels der Transportvorrichtung auf einem Transportweg in eine Bestückposition transportiert. In der Bestückposition erfolgt das Bestücken der Substrate. Hierbei werden auf die Oberflächen der Substrate Bestückelemente mittels einer Handhabungseinrichtung, beispielsweise einer Bestückvorrichtung, wie einem Revolver-Bestückkopf, aufgebracht. Während des Bestückens mittels der Bestückvorrichtung wird eine Kraft auf die Oberfläche des zu bestückenden Substrats ausgeübt. Insbesondere Substrate mit geringer Dicke werden durch die während des Bestückens aufgebrachte Kraft sehr leicht durchgebogen. Es ist daher erforderlich, die Substrate entsprechend abzustützen, um ein exaktes Bestücken sicher zu stellen. Hierzu wird herkömmlicherweise ein Träger verwendet, welcher, nachdem das Substrat die Bestückposition erreicht hat, an eine Oberfläche des Substrats angelegt wird, um das Substrat in dem Bereich zwischen den Auflagepunkten des Substrats an der Transportvorrichtung abzustützen.

Häufig ist jedoch auch jene Oberfläche des Substrats, an welcher der Träger angelegt wird, mit Bestückelementen versehen, so dass bei angelegtem Träger ein Weitertransport des Substrats zu einer Beschädigung des Substrats und/oder des Trägers führen würde.

Um derartige Beschädigungen zu vermeiden, muss der Träger herkömmlicherweise von der Oberfläche des Substrats zurückgezogen und bis an das Ende seines Bewegungsbereichs verbracht werden. Erst danach ist es möglich, das Substrat aus der Bestückposition mittels der Transportvorrichtung weiter zu transportieren. Die herkömmliche Vorgehensweise weist jedoch hinsichtlich der Durchlaufgeschwindigkeit von Substraten durch Bestückeinrichtungen erhebliche Nachteile auf, da jeweils die gesamte Zeitdauer, welche der Antrieb des Trägers benötigt, um von der Oberfläche des Substrats an das Ende seines Bewegungsbereiches zu gelangen, abgewartet werden muss, ehe der Transport des Substrats des Substrats an der Bestückvorrichtung freigegeben werden kann.

Der Erfindung liegt die Aufgabe zugrunde, ein Verfahren zum Bestücken und eine Schutzeinrichtung für Bestückeinrichtungen anzugeben, bei welchen die Durchlaufgeschwindigkeit der Substrate erhöht ist und Beschädigungen der Substrate vermieden sind.

Diese Aufgabe wird gelöst durch ein Verfahren mit dem Merkmal nach Anspruch 1 sowie durch eine Schutzeinrichtung für Bestückeinrichtungen mit den Merkmalen nach Anspruch 2. Bevorzugte Ausgestaltungen der Erfindung sind in den abhängigen Ansprüchen beansprucht.

Durch das erfindungsgemäße Verfahren nach Anspruch 1 ist es möglich, abhängig von der Höhe des größten zu bestückenden Bestückelements ein zu bestückendes Substrat bereits sehr kurz nach dem Entfernen des Trägers von der Oberfläche des Substrats zum Transportieren mittels der Tansportvorrichtung freizugeben. Hierbei wird der Träger, welcher das Substrat während des Bestückens abstützt, lediglich soweit von der Oberfläche des Substrats entfernt, dass beim Weitertransportieren des Substrats eine Kollision des Trägers mit Bestückelementen auf dem Substrat vermieden wird. Hierzu kann beispielsweise ein Wegaufnehmer verwendet werden, welcher in Zusammenwirken mit einer Steuervorrichtung, welcher die Höhe des größten zu bestückenden Bestückelements vorgebbar ist, die Transportvorrichtung zum Transportieren des Substrats aus der Bestückposition freigeben kann.

Bei bekannter Höhe des größten zu bestückenden Bestückelements wird eine Sicherheitsposition des Trägers vorgegeben. Diese entspricht einem Abstand des Trägers von dem zu bestückenden Substrat, welche mindestens der Höhe des größten zu bestückenden Bestückelements entspricht. Das Transportieren des Substrats aus der Bestückvorrichtung bleibt solange gesperrt, bis der Träger sich in der Sicherheitsposition befindet und der Abstand zwischen dem Substrat und dem Träger mindestens der Höhe des größten zu bestückenden Bestückelements entspricht. Erst bei Erreichen dieser Sicherheitsposition wird die Transportvorrichtung freigegeben, um das Substrat aus der Bestückposition heraustransportieren zu können.

Eine erfindungsgemäße Schutzeinrichtung für Bestückeinrichtungen, in denen Substrate an ihren Oberflächen mit Bestückelementen versehen werden und relativ zu Bestückvorrichtungen mittels einer steuerbaren Transportvorrichtung auf einem Transportweg in eine Bestückposition transportiert werden, weist einen Wegaufnehmer auf, von welchem die Position des Trägers relativ zu dem Substrat erfassbar ist. Ferner weist die erfindungsgemäße Schutzeinrichtung eine Steuervorrichtung auf, welche mit dem Antrieb des Trägers, mit der Transportvorrichtung sowie mit dem Wegaufnehmer gekoppelt ist. Der Schutzeinrichtung ist eine Sicherheitsposition des Trägers vorgebbar. Die Sicherheitsposition ist mindestens um die Höhe des größten zu bestückenden Bestückelements von dem Substrat beabstandet. Mittels der Steuervorrichtung ist es möglich, unter Auswerten der von dem Wegaufnehmer erfassten Position des Trägers relativ zu dem Substrat sowie Vergleichen mit der Sicherheitsposition des Trägers, die Transportvorrichtung zum Transportieren des Substrats aus der Bestückposition freizugeben, sobald der Träger die Sicherheitsposition erreicht hat.

Hierdurch ist ein schnellstmögliches Weitertransportieren des zu bestückenden Substrats aus der Bestückposition bei gleichzeitig maximaler Sicherheit gegen Beschädigungen des Trägers und/oder des Substrats gewährleistet, da das Weitertransportieren des Substrats aus der Bestückposition erst erfolgen kann, sobald der Träger einen sicheren Abstand von dem Substrat eingenommen hat.

Nach der Ausgestaltung nach Anspruch 3 kommen für den Wegaufnehmer optische Aufnehmer, induktive Aufnehmer, magnetische Aufnehmer, resistive Aufnehmer oder inkrementale Aufnehmer in Frage. Es ist auch eine Kombination der genannten Arten von Aufnehmern möglich. Beispielsweise kann mittels zweier Gabellichtschranken und einem mit Inkrement-Markierungen versehenen Abstastelement ein derartiger Wegaufnehmer gebildet sein.

Durch die Ausgestaltung nach Anspruch 4 ist es möglich, auch bei über eine Welle angetriebenen Träger einen Wegaufnehmer, in Form eines Winkelaufnehmers, an dem Antrieb des Trägers anzuordnen. Hierdurch lässt sich die erfindungsgemäße Schutzeinrichtung für Bestückeinrichtungen bei sehr geringem vorhandenen Bauraum verwenden.

Die Erfindung wird unter Bezugnahme auf die Zeichnung näher erläutert. In der Zeichnung zeigen:
Figur 1 eine perspektivische Ansicht eines Wegaufnehmers nach einer Ausführungsform der Erfindung und
Figur 2 eine schematische Seitenansicht einer bevorzugten Ausführungsform der Erfindung.

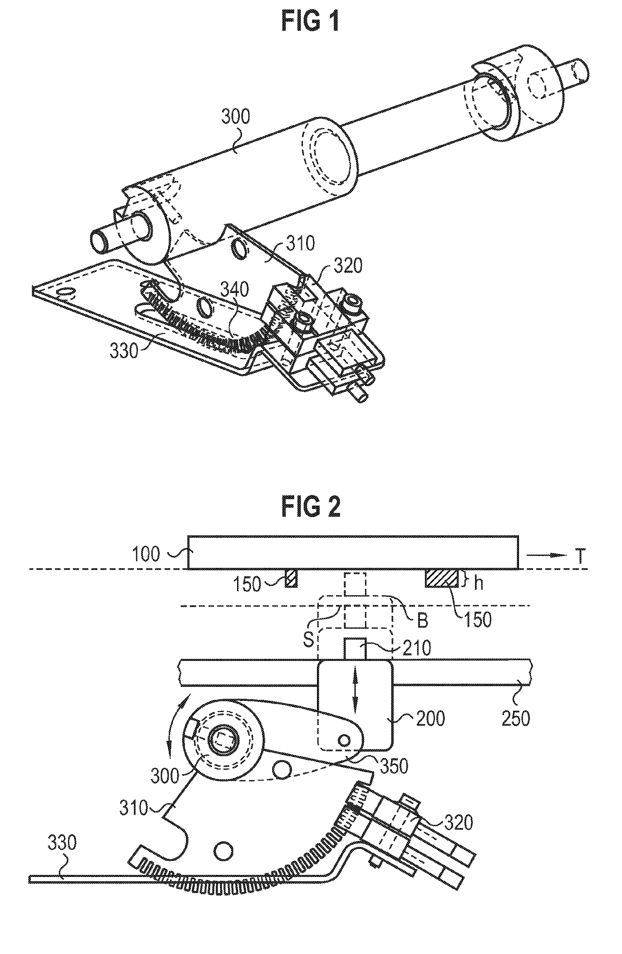

Aus Figur 1 ist eine Antriebswelle 300 für einen Träger (nicht gezeigt) der eingangs genannten Art ersichtlich. An der Antriebswelle 300 ist ein Inkrement-Segment 310 angebracht und radial ausgerichtet, so dass die an dem Inkrement-Segment 310 ausgebildeten Inkrement-Markierungen 340 beim Drehen der Antriebswelle 300 in der Umfangsrichtung der Antriebswelle 300 bewegt werden. Relativ zu dem Inkrement-Segment 310 und der Antriebswelle 300 ist eine Grundplatte 330 angeordnet, an welcher optische Aufnehmer 320 befestigt sind. Die optischen Aufnehmer 320 und die Inkrement-Markierungen 340 wirken zusammen als Wegaufnehmer. Beispielsweise sind die optischen Aufnehmer 320 zwei Gabellichtschranken und das Inkrement-Segment 310 mit den Inkrement-Markierungen durchläuft mit seinem Umfangsbereich, in welchem die Inkrement-Markierungen 340 ausgebildet sind, den Strahlengang der Gabellichtschranken.

Aus Figur 2 ist eine bevorzugte Ausführungsform der Erfindung ersichtlich, bei welcher der aus Figur 1 ersichtlich Wegaufnehmer verwendet wird. Zusätzlich zu den in Figur 1 beschriebenen Elementen weist die bevorzugte Ausführungsform einen an der Welle vorgesehenen Nocken 350 auf. Der Nocken 350 ist gelenkig mit einem Träger 200 verbunden. Durch die gelenkige Verbindung des Nockens 350 mit dem Träger 200, welcher in einer Aufnahme 250 in einer Richtung geführt gelagert ist, kann eine Drehbewegung der Welle 300 in eine Linearbewegung des Trägers 200 umgesetzt werden. Relativ zu derAufnahme 250 wird ein Substrat 100, welches zu bestücken ist, in einem bestimmten Abstand mittels einer Transportvorrichtung (nicht gezeigt) in einer Bestückposition relativ zu dem Träger 200 angeordnet. Durch Drehen der Welle 300 und daraus folgender Linearbewegung des Trägers 200 auf das Substrat 100 zu wird der Träger 200 mit einem Kontaktstück 210, das an der Oberseite des Trägers 200 angebracht ist, an das Substrat 100 angelegt, so dass das Substrat 100 von dem Träger abgestützt ist.

Nach dem Bestücken des Substrats 100 in Bestückposition soll das Substrat 100 in der Transportrichtung T mittels der Transportvorrichtung (nicht gezeigt) aus der Bestückposition transportiert werden. Hierbei muss der Träger 200 von dem Substrat 100 entfernt werden, da auch auf der dem Träger 200 zugewandten Oberfläche des Substrats 100 Bestückelemente 150 einer maximalen Höhe h angeordnet sein können. Ohne Entfernen des Trägers 200 von dem Substrat 100 bestünde die Gefahr einer Kollision der Bestückelemente 150 mit dem Träger 200. Um der Gefahr zu begegnen, wird erfindungsgemäß der Träger 200 aus seiner Bestückposition B in eine Sicherheitsposition S verbracht, in welcher der Abstand zwischen dem Träger 200 und dem Substrat 100 mindestens der größten Höhe h der Bestückelemente 150 über der Oberfläche des Substrats 100 entspricht. Hierdurch ist sichergestellt, dass die an dem Substrat 100 angeordneten Bestückelemente 150 nicht mit dem Träger 200
kollidieren können und gleichzeitig das Transportieren des Substrats 100 in der Transportrichtung T aus der Bestückposition sehr schnell nach dem Bestücken des Substrats 100 freigegeben werden kann.

## Patentansprüche

1. Verfahren zum Bestücken von Bestückelementen auf Substrate, bei welchem die Substrate (100) an ihren Oberflächen mit Bestückelementen (150) versehen werden und relativ zu Bestückvorrichtungen mittels einer steuerbaren Transportvorrichtung auf einem Transportweg (T) in eine Bestückposition transportiert werden, wobei an der Bestückvorrichtung ein winkelig zu dem Transportweg (T) steuerbar angetriebener Träger (200) vorgesehen ist, mittels welchem die Substrate (100) an einer der zu bestückenden oder an einer bestückten Oberfläche während des Bestückens abgestützt werden, **dadurch gekennzeichnet, dass**
• die Position des Trägers (200) relativ zu dem Substrat (100) erfaßt wird,
• eine Sicherheits-Position (S) des Trägers (200) vorgegeben wird, welche mindestens um die Höhe des größten Bestückelements (150) von dem Substrat (100) beabstandet ist,
• ein Transportieren des Substrats (100) mittels der Transportvorrichtung gesperrt wird, solange sich der Träger (200) an der Oberfläche des Substrats (100) oder zwischen dem Substrat (100) und der Sicherheitsposition (S) befindet, und
• bei Erreichen der Sicherheits-Position (S) das Substrat (100) zum Transportieren mittels der Transportvorrichtung freigegeben wird.

2. Schutzeinrichtung für Bestückeinrichtungen, in denen Substrate (100) an ihren Oberflächen mit Bestückelementen (150) versehen werden und relativ zu Bestückvorrichtungen mittels einer steuerbaren Transportvorrichtung auf einem Transportweg (T) in eine Bestückposition transportiert werden, wobei an der Bestückvorrichtung ein winkelig zu dem Transportweg (T) steuerbar angetriebener Träger (200) vorgesehen ist, mittels welchem die Substrate (100) an einer der zu bestückenden oder an einer bestückten Oberfläche während des Bestückens mit Bestückelementen (150) in der Bestückposition abstützbar sind, **dadurch gekennzeichnet, dass**
• ein Wegaufnehmer vorgesehen ist, von welchem die Position des Trägers (200) relativ zu dem Substrat (100) erfassbar ist,
• eine Sicherheits-Position (S) des Trägers (200) vorgebbar ist, welche mindestens um die Höhe (h) des größten Bestückelements (150) von dem Substrat (100) beabstandet ist, und
• eine mit dem Antrieb des Trägers (200), mit der Transportvorrichtung und mit dem Wegaufnehmer gekoppelte Steuervorrichtung vorgesehen ist, von welcher das Transportieren des Substrats (100) aus der Bestückposition freigebbar ist, sobald der Träger (200) die Sicherheits-Position (S) erreicht hat.

3. Schutzeinrichtung nach Anspruch 2, **dadurch gekennzeichnet, dass**
• der Wegaufnehmer ein optischer Aufnehmer, ein induktiver Aufnehmer, ein magnetischer Aufnehmer, ein resistiver Aufnehmer oder ein inkrementaler Aufnehmer ist.

4. Schutzeinrichtung nach Anspruch 2 oder 3, **dadurch gekennzeichnet, dass**
• der Träger (200) an einem mit einer Welle (300) verbundenen Exzenter (350) gelagert und durch Drehen der Welle linear bewegbar ist, und
• der Wegaufnehmer ein an der Welle (300) angeordneter Winkelaufnehmer (320, 340) ist.
